Europäisches Patentamt

**European Patent Office**

**Office européen des brevets**

(11) Publication number:

**0 328 180**
**A1**

## (12) EUROPEAN PATENT APPLICATION

(21) Application number: 89200195.9

(22) Date of filing: 31.01.89

(51) Int. Cl.4: **H03G 1/04** , **H03G 3/20** , **H03F 1/32**

(30) Priority: 05.02.88 NL 8800274

(43) Date of publication of application:
**16.08.89 Bulletin 89/33**

(84) Designated Contracting States:
**DE FR GB IT NL**

(71) Applicant: **N.V. Philips' Gloeilampenfabrieken**
**Groenewoudseweg 1**
**NL-5621 BA Eindhoven(NL)**

(72) Inventor: **Van den Bungelaar, Martinus**
**Joseph**
**c/o INT. OCTROOIBUREAU B.V. Prof.**
**Holstlaan 6**
**NL-5656 AA Eindhoven(NL)**

(74) Representative: **Peters, Rudolf Johannes et al**
**INTERNATIONAAL OCTROOIBUREAU B.V.**
**Prof. Holstlaan 6**
**NL-5656 AA Eindhoven(NL)**

(54) Amplifier arrangement with output-swing limitation.

(57) An amplifier (1) comprises a detection device (8, 10) which is constructed to generate a control signal $(I_2)$ when one of the output transistors $(T_1)$ becomes saturated as a result of overdriving, which control signal is applied to a control input (22) of a conventional volume controller (20), which in response thereto attenuates the input voltage $(V_i)$ of the amplifier. As a result of this, the drive to the output transistors $(T_1, T_2)$ is reduced without the output signal being distorted significantly.

EP 0 328 180 A1

FIG. 1

## Amplifier arrangement with output-swing limitation.

The invention relates to a device comprising
- an amplifier arrangement for amplifying an input signal, which arrangement comprises two output transistors whose main current paths are arranged in series between two power-supply terminals, and
- a control device for attenuating the input signal of the amplifier arrangement in response to a control signal applied to the control device.

Such a device is very suitable for use in audio amplifiers.

In amplifier arrangements it is generally undesirable to drive the output transistors into full saturation because the powersupply voltage then puts a limitation on the output signal of the amplifier, so that this signal is greatly distorted. It is common practice to preclude this by measuring the current in the relevant output transistor by means of a resistor arranged in the emitter or collector line and, when a specific threshold value is exceeded, turning on a transistor with the voltage across this resistor, which transistor then drains a part of the drive signal for the output transistor and thereby reduces the drive to the output transistor.

A drawback of this method is that by draining a part of the drive signal the actual drive signal of the output transistor and hence the output signal of the amplifier are distorted.

Therefore, it is an object of the invention to provide a device in which the drive of the output transistors is limited so as to minimize distortion of the output signal.

According to the invention a device of the type defined in the opening paragraph is characterized in that the device further comprises
- a detection device for generating a detection signal when at least one of the output transistors of the amplifier arrangement becomes saturated, and
- in that the control device is adapted to attenuate the input signal in response to the detection signal from the detection device.

The invention is based on the recognition of the fact that when the maximum output swing of the amplifier arrangement is reached the drive of the output transistors can be reduced without significant distortion of the output signal by applying a saturation-detection signal to the controller commonly used in such an amplifier arrangement, to attenuate the input signal of the amplifier arrangement.

An embodiment of a device in accordance with the invention may be characterized in that the detection device comprises a comparator having a non-inverting input coupled to the control electrode of the relevant output transistor by means of a resistor, having an inverting input coupled to a point of reference potential, and having an output coupled to an input of an inverting current amplifier which has an output coupled to a control input of the control device. This detection device does not detect a specific current through the output transistor but it detects whether the output transistor is driven into saturation. Its operation is based on the recognition of the fact that when saturation occurs the current-gain factor of the transistor decreases strongly, so that the base current increases strongly, resulting in an increased voltage drop across the base resistor. This increase is detected by means of a comparator and the output signal of said comparator is applied to the control device via a current amplifier having a high-impedance output. Suitably, the resistor is constituted by the intrinsic base resistance of the relevant output transistor.

A suitable and simple embodiment of the detection device is characterized in that the comparator comprises a transistor which is of a conductivity type opposite to that of the relevant output transistor and whose emitter constitutes the non-inverting input and whose base constitutes the inverting input. Suitably, the inverting current amplifier is constituted by a current mirror.

A further embodiment of the device in accordance with the invention may be characterized in that the output of the detection device is connected to the control input of the control device by means of an integrator, which integrator, in a further embodiment, may comprise a series arrangement of a resistor and a capacitor connected between the output of the detection device and a first power-supply terminal, the junction point between said resistor and capacitor being connected to said control input, and to a second power-supply terminal by means of a resistor.

The invention will now be described in more detail, by way of example, with reference to the accompanying drawing, in which

Figure 1 shows a basic diagram of a device in accordance with the invention, and

Figure 2 shows an embodiment of a device in accordance with the invention.

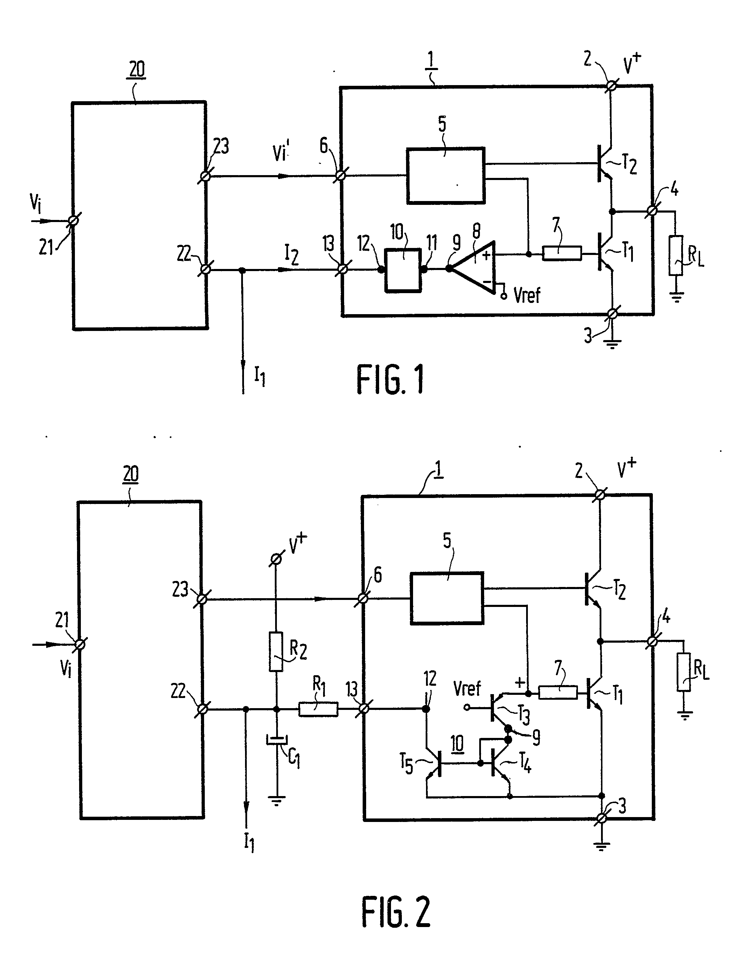

Figure 1 is a basic diagram of a device in accordance with the invention. This diagram shows only those parts which are relevant to the invention. The reference numeral 1 indicates an amplifier arrangement which is suitably constructed as a fully integrated circuit. The amplifier arrangement comprises two output transistors $T_1$ and $T_2$, whose collector-emitter paths are arranged in series between a first power-supply terminal 2 for a positive power-supply voltage $+V$ and a second power-supply terminal 3 for a negative power-supply voltage, in the present case earth. The collector of the transistor $T_1$ and the emitter of the transistor $T_2$ are connected to an output 4 intended for connection of a load $R_1$. The bases of the output transistors $T_1$ and $T_2$ are driven in phase-opposition by a drive circuit 5 having an input 6 to which the input signal $V_i'$ of the amplifier arrangement 1 is applied. The amplifier arrangement described so far may be of any known type, for example the type used in the Philips ICs TDA 1514 and TDA 1516.

In accordance with the invention the amplifier arrangement 1 is provided with a detection device for generating a detection signal $I_2$ when the transistor $T_1$ is saturated. In the present case this device comprises a comparator 8 whose non-inverting input is connected to the base of the transistor $T_1$ via a resistor 7 and whose inverting input is connected to a point of reference potential. It is to be noted that the resistor 7 may be constituted by the intrinsic base resistance of the transistor $T_1$. The output of the comparator 8 is connected to the input 11 of an inverting current amplifier 10, whose output 12 is connected to a terminal 13 of the amplifier arrangement 1. It is to be noted that the detection device need not necessarily comprise a comparator and an inverting current amplifier. For example, the detection device may comprise a circuit which by comparison detects that the output signal of the amplifier arrangement is not in track with the input signal.

Further it is to be noted that a similar detection device may be coupled to the transistor $T_2$.

The device in accordance with the invention further comprises a control device 20, by means of which an input signal Vi applied to an input 21 can be attenuated by means of a control signal $I_1$ applied to a control input 22 and is available on an output 23 to be applied to the input 6 of the amplifier arrangement 1. The control device 20 constitutes a volume controller or sound processor which is generally used in combination with an amplifier arrangement 1. Such a volume controller may be constructed for example as an electrical potentiometer, the current distribution in one or more differential pairs being controlled by the control signal. A volume controller based on this principle is employed in the Philips IC TDA 1074A. Alternatively the control device may be constructed as a sound processor in which the signal is attenuated digitally. Such a sound processor is available, for example, from Philips as the IC TDA 8420. Such volume controllers and sound processors are generally known and are therefore not described in more detail.

The circuit arrangement operates as follows. If the transistor $T_1$ is driven into saturation the current-gain factor of the transistor $T_1$ decreases

strongly, so that the base current increases strongly. The voltage drop across the base resistor 7 and hence the voltage on the non-inverting input of the comparator 8 then increase. If this voltage becomes higher than the reference voltage $V_{ref}$ on the inverting input the comparator 8 will supply a current via its output 9. This current is applied to the input 11 of the inverting current amplifier 10, whose output current $I_2$ is applied to the control input 22 of the volume controller 20. This control signal $I_2$ changes the setting dictated by the control signal $I_1$ so as to attenuate the output signal $V_f$, supplied to the input 6 of the amplifier arrangement by the volume controller. Thus, the drive to the output transistor $T_1$ is reduced, so that it is no longer saturated. In this way clipping of the output signal of the amplifier arrangement 1 is minimized without introducing any significant distortion of the drive signal of the transistor $T_1$.

Figure 2 shows a practical embodiment of the basic circuit arrangement shown in Figure 1. The comparator now comprises a PNP transistor $T_3$, whose emitter constitutes the non-inverting input, whose base constitutes the inverting input, and whose collector constitutes the output 9 of the comparator 8. The inverting current amplifier 10 is constituted by a current mirror comprising a diode-connected transistor $T_4$ and a transistor $T_5$, whose base-emitter junction is arranged in parallel with said diode-connected transistor and whose collector constitutes the high-impedance output of the current mirror. It is to be noted that the current mirror 10 may be replaced by any other type of current mirror. The output 12 of the current mirror is connected to the control input 22 of the volume controller 20 by an integrator comprising a resistor $R_1$ and a capacitor $C_1$, said control input being also connected to the positive power-supply by means of a resistor $R_2$. It is to be noted that this supply voltage may also be constituted by a reference generated internally in the volume controller 20. As long as the output transistors are not overdriven and the output 12 of the current amplifier 10 does not carry a current the capacitor $C_1$ is charged to the positive supply voltage or to a voltage defined by the control signal $I_1$. If the transistor $T_1$ is overdriven the capacitor $C_1$ is discharged by the output current of the current amplifier 10, so that the input voltage of the volume controller is reduced and, consequently, the input signal $V_f$ of the amplifier arrangement is attenuated. If overdriving ceases the capacitor $C_1$ is recharged via the resistor $R_2$ and the original control voltage on the input 22 is restored. The time constant of the resistor $R_1$ and the capacitor $C_1$ can be selected in such a way that a brief overdrive of the output transistors will hardly affect the voltage on the input 22 of the volume controller 20.

The invention is not limited to the embodiments shown. For example, the comparator and the inverting current amplifier may be of any other construction than shown.

## Claims

1. A device comprising
- an amplifier arrangement for amplifying an input signal, which arrangement comprises two output transistors whose main-current paths are arranged in series between two power-supply terminals,
- a control device for attenuating the input signal of the amplifier arrangement in response to a control signal applied to the control device, characterized in that the device further comprises
- a detection device for generating a detection signal when at least one of the output transistors of the amplifier arrangement becomes saturated, and
- in that the control device is adapted to attenuate the input signal in response to the detection signal from the detection device.

2. An integrated amplifier arrangement for amplifying an input signal, comprising two output transistors whose main-current paths are arranged in series between two power-supply terminals, characterized in that the amplifier arrangement is provided with a detection device for generating a detection signal when at least one of the output transistors of the amplifier arrangement becomes saturated.

3. A device as claimed in Claim 1 or 2, characterized in that a detection device comprises a comparator having a non-inverting input coupled to the control electrode of the relevant output transistor by means of a resistor, having an inverting input coupled to a point of reference potential, and having an output coupled to an input of an inverting current amplifier which has an output constituting the output of the detection device.

4. A device as claimed in Claim 2, characterized in that the comparator comprises a transistor which is of a conductivity type opposite to that of the relevant output transistor and whose emitter constitutes the non-inverting input and whose base constitutes the inverting input.

5. A device as claimed in Claim 3 or 4, characterized in that the resistor is constituted by the intrinsic base resistance of the relevant output transistor.

6. A device as claimed in Claim 3, 4 or 5, characterized in that the inverting current amplifier is constituted by a current mirror.

7. A device as claimed in Claim 6, characterized in that the current mirror comprises a transistor having its base connected to its collector and to the input and having its base also connected to the base of a further transistor whose collector constitutes the output of the current mirror.

8. A device as claimed in any one of the preceding Claims 1 and 3 to 7, characterized in that the output of the detection device is connected to the control input of the control device by means of an integrator.

9. A device as claimed in Claim 7, characterized in that the integrator comprises a series arrangement of a resistor and a capacitor connected between the output of the detection device and a first power-supply terminal, the junction point between said resistor and capacitor being connected to said control input, and to a second power-supply terminal by means of a resistor.

FIG.1

FIG.2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 155 717  (N.V. PHILIPS) <br> * Figure 1; page 4, line 12 - page 6, line 38 * <br> --- | 1,2 | H 03 G    1/04 <br> H 03 G    3/20 <br> H 03 F    1/32 |
| A | PATENT ABSTRACTS OF JAPAN, vol 9, no. 47 (E-299)[1770], fevrier 1985; & JP-A-59 188 208 (ONKYO K.K.) 25-10-1984 <br> ----- | 1,2 | |

**DOMAINES TECHNIQUES RECHERCHES (Int. Cl.4)**

H 03 G
H 03 F

Le présent rapport a été établi pour toutes les revendications

| Lieu de la recherche | Date d'achèvement de la recherche | Examinateur |
|---|---|---|
| LA HAYE | 12-05-1989 | DECONINCK E.F.V. |